# FASCICULE DE BREVET EUROPEEN

(11) **EP 0 647 018 B1**
(45) Date de publication et mention de la délivrance du brevet: **29.04.1998**
(21) Numéro de dépôt: 94410083.3
(22) Date de dépôt: 27.09.1994
(51) Int. Cl.: H03D 13/00

(54) **Comparateur de phase numérique**
Digitaler Phasenkomparator
Digital phase comparator

(30) Priorité: 30.09.1993 FR 9311864
(43) Date de publication de la demande: 05.04.1995
(73) Titulaire: SGS-THOMSON MICROELECTRONICS S.A., 94250 Gentilly (FR)
(72) Inventeur: Meyer, Jacques, F-38700 Corenc (FR)
(74) Mandataire: de Beaumont, Michel

(56) Documents cités:
- EP-A- 0 552 601
- US-A- 4 351 002
- US-A- 4 654 586

## Description

La présente invention concerne les boucles à verrouillage de phase (PLL), et en particulier un comparateur de phase numérique utilisé dans un PLL dont tous les éléments sont réalisés de façon numérique.

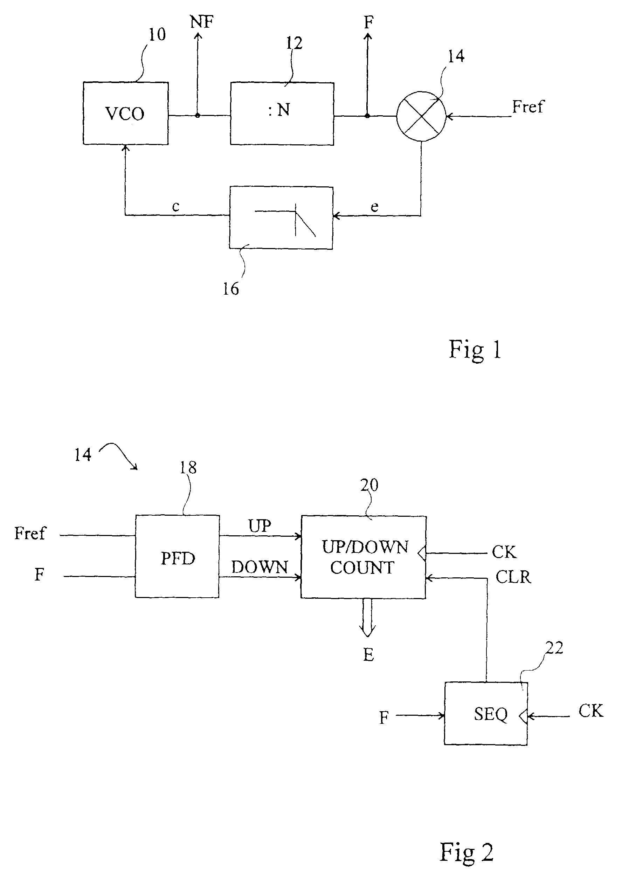

La figure 1 représente schématiquement une architecture classique de PLL. Le PLL comprend un oscillateur commandé en tension (VCO) 10 délivrant une fréquence NF à un diviseur par N 12. Un comparateur de phase 14 reçoit la fréquence de sortie F du diviseur 12 et une fréquence de référence Fref. Le comparateur de phase 14 fournit un signal d'erreur de phase e à un filtre 16 dont la sortie c commmande l'oscillateur 10. En régime établi, le signal F est calé en phase et en fréquence sur le signal Fref. Dans une application courante, par exemple dans le balayage horizontal d'un téléviseur, la fréquence F à obtenir est de l'ordre de 15 kHz, la fréquence NF de l'ordre de 12 MHz (N = 768), et le filtre 16 est un filtre passe-bas dont la fréquence de coupure est de quelques centaines de hertz.

Actuellement, on tend à réaliser tous les éléments d'un PLL sous forme de circuits numériques. Ceci permet d'éviter l'emploi de capacités de grande valeur difficilement intégrables, de rendre les éléments programmables, et de simplifier les opérations de conception en permettant d'utiliser des blocs standards en technologie MOS ou CMOS.

La figure 2 représente un comparateur de phase 14 numérique classique. Ce comparateur de phase comprend un détecteur de phase/fréquence (PFD) 18 recevant les signaux Fref et F. Il fournit des impulsions UP de largeurs égales aux retards de phase du signal F par rapport au signal Fref, et des impulsions DOWN de largeurs égales aux avances de phase du signal F par rapport au signal Fref. Un compteur/décompteur 20 reçoit un signal d'horloge CK de fréquence élevée par rapport à celle des signaux Fref et F. Le comptage du compteur/décompteur 20 est validé par des impulsions UP, et le décomptage par les impulsions DOWN. Un séquenceur 22 recevant les signaux F et CK, remet à zéro le compteur/décompteur 20 entre deux fronts du signal F, après que le contenu de celui-ci est exploité par le filtre.

Avec cette configuration, après chaque impulsion UP ou DOWN, le compteur/décompteur 20 contient une valeur numérique E correspondant à l'erreur de phase recherchée.

Les deux fronts de chaque impulsion UP ou DOWN correspondent respectivement à un front du signal Fref et à un front du signal F. Ainsi, s'il survient une impulsion parasite avant le front à prendre en compte du signal Fref ou F, l'impulsion UP ou DOWN alors générée est raccourcie ou rallongée de façon erronée. Un tel comparateur de phase ne convient pas pour traiter des signaux de balayage horizontal dans un téléviseur, car le signal Fref peut alors comporter de nombreuses impulsions parasites.

En outre, pour obtenir un comparateur de phase suffisamment précis, le signal d'horloge CK doit être de fréquence particulièrement élevée. Par exemple, dans le cadre d'un balayage horizontal de téléviseur, la fréquence de ce signal CK doit être de l'ordre de 200 mégahertz. Les technologies courantes ne permettent pas de réaliser un compteur/décompteur aussi rapide.

Le brevet américain 4 351 002 décrit un comparateur de phase numérique fournissant des valeurs numériques correspondant aux différences de phase entre un premier signal et un deuxième signal, comprenant un compteur à sens unique initialisé à la fréquence du premier signal et cadencé par un signal d'horloge de fréquence élevée par rapport à celle des premier et deuxième signaux, et une porte logique pour valider le compteur.

Les fronts des premier et deuxième signaux provoquent des changements d'état de bascules, et ce sont les états de ces bascules qui déterminent la validation ou non du compteur par l'intermédiaire de la porte logique. Ainsi, ce comparateur de phase est sensible aux fronts des premier et deuxième signaux et présente donc l'inconvénient d'être sensible aux impulsions parasites.

Un objet de la présente invention est de réaliser un comparateur de phase numérique qui puisse fonctionner avec une fréquence d'horloge particulièrement élevée.

Un autre objet de la présente invention est de réaliser un comparateur de phase numérique peu sensible à des impulsions parasites.

Ces objets sont atteints grâce à un comparateur de phase numérique décrit dans la revendication 1 et similaire à celui du brevet américain susmentionné et qui se différencie en ce que le premier signal a un rapport cyclique sensiblement égal à 0,5 et en ce que la porte logique est connectée pour valider le compteur quand les premier et deuxième signaux sont à des états respectifs prédéterminés, une différence de phase étant considérée comme nulle lorsqu'elle correspond à la moitié de la capacité du compteur.

Selon un mode de réalisation de la présente invention, le comparateur comprend une bascule coopérant avec ladite porte logique pour valider le compteur seulement quand un front prédéterminé du deuxième signal arrive quand le premier signal est à son état prédéterminé respectif.

Selon un mode de réalisation de la présente invention, le comparateur comprend un circuit de traitement du premier signal pour diminuer la durée de l'état prédéterminé respectif de celui-ci de la durée correspondant au comptage par le compteur jusqu'à la moitié de sa capacité.

Selon un mode de réalisation de la présente invention, le comparateur comprend un générateur d'horloge fournissant plusieurs signaux d'horloge de même fréquence mais déphasés d'une valeur constante, ces signaux d'horloge étant successivement fournis au compteur à la fréquence du premier signal.

Ces objets, caractéristiques et avantages ainsi que d'autres de la présente invention seront exposés en détail dans la description suivante de modes de réalisation particuliers faite à titre non limitatif en relation avec les figures jointes parmi lesquelles :
la figure 1, précédemment décrite, représente une boucle à verrouillage de phase (PLL) classique ;
la figure 2, précédemment décrite, représente un comparateur de phase numérique classique ;
la figure 3A représente un mode de réalisation de comparateur de phase numérique selon l'invention ;
la figure 3B représente des signaux utilisés dans le comparateur de phase de la figure 3A ;
la figure 4 représente un diagramme de l'erreur fournie par le comparateur de phase de la figure 3A en fonction de l'erreur réelle ;
la figure 5 représente des signaux au démarrage du comparateur de la figure 3A ;
la figure 6 représente un mauvais fonctionnement du comparateur de la figure 3A dans le cas particulier où l'un de ses signaux d'entrée présente un rapport cyclique variable ;
la figure 7 représente un mode de réalisation de comparateur de phase numérique selon l'invention permettant d'éviter l'inconvénient de la figure 6 ;
la figure 8 représente un diagramme de l'erreur de phase fournie par le comparateur de la figure 7 en fonction de l'erreur de phase réelle ; et
les figures 9A et 9B représentent un autre mode de réalisation de comparateur de phase selon l'invention et un diagramme illustrant son fonctionnement.

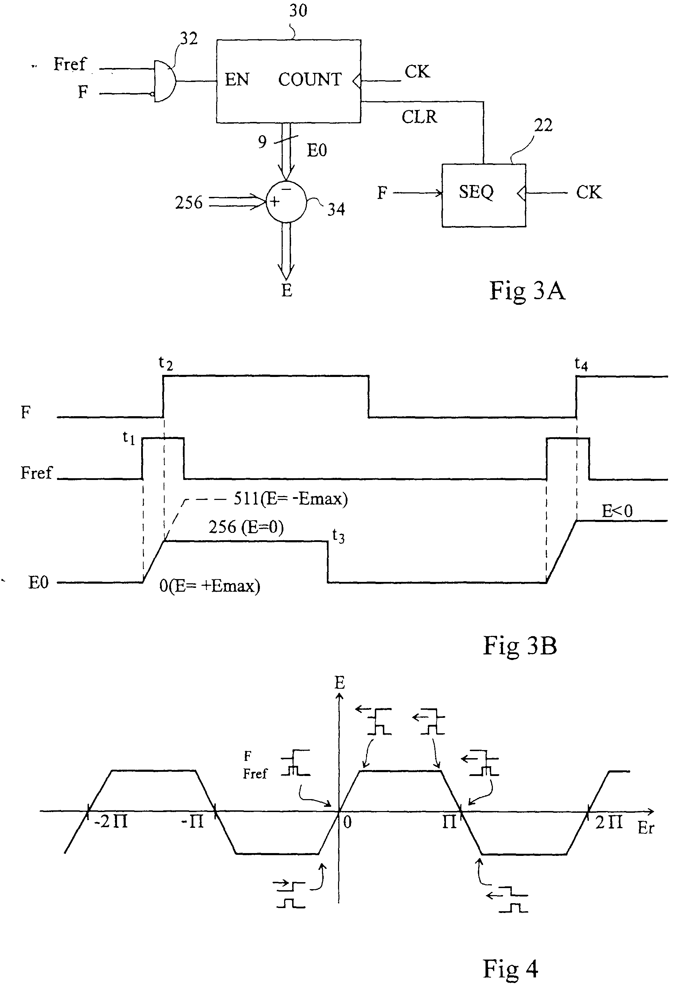

Comme le représente la figure 3A, un comparateur de phase numérique selon l'invention utilise un compteur à sens unique 30 qui a l'avantage, s'il est asynchrone, de pouvoir fonctionner avec un signal d'horloge CK de fréquence aussi élevée qu'environ 200 MHz dans les technologies courantes actuelles (ce qui n'est pas le cas des compteurs-décompteurs). Sur une entrée de validation EN, le compteur 30 reçoit la sortie d'une porte ET 32 recevant sur une entrée le signal Fref et sur une autre entrée le signal F inversé.

Avec cette configuration, le signal de validation EN fourni par la porte 32 est sensible aux états des signaux Fref et F et non à leurs fronts ; si l'un des signaux Fref et F présente une impulsion parasite, le signal de validation EN n'est actif que pendant la durée de l'impulsion parasite et le contenu du compteur 30 varie très peu. Comme le compteur-décompteur de la figure 2, le compteur 30 est remis à zéro périodiquement par un signal CLR fourni par un séquenceur 22 recevant les signaux F et CK.

Le contenu E0 du compteur 30, qui est par exemple codé sur 9 bits, est soustrait à une valeur constante (256) correspondant à la moitié de la capacité du compteur 30 par un sous-tracteur 34 qui fournit l'erreur de phase numérique E.

La figure 3B illustre un exemple d'allure des signaux F et Fref et la variation correspondante du contenu E0 du compteur 30. Le signal F, fourni par le diviseur 12 (figure 1) d'un PLL, présente un rapport cyclique de 0,5. Dans le système de balayage horizontal d'un téléviseur, le signal Fref correspond à des impulsions de synchronisation de largeur supposée constante (environ 4,7 microsecondes). La fréquence de l'horloge CK est choisie pour que le compteur compte jusqu'à sa valeur maximale (511) pendant la durée d'une impulsion du signal Fref. Ainsi, si une impulsion du signal Fref est centrée sur un front montant du signal F, le compteur atteint une valeur (256) égale à la moitié de sa capacité. Cette valeur moitié est choisie pour correspondre à une erreur de phase nulle ; on synchronise les fronts montants du signal F sur les centres des impulsions du signal Fref.

A un instant t₁, survient un front montant d'une impulsion du signal Fref. Le compteur 30, initialement à zéro, est validé et commence à compter.

A un instant t₂ qui, dans cet exemple, correspond au centre de l'impulsion du signal Fref, survient un front montant du signal F. Le compteur 30 est arrêté à la moitié de sa capacité 256. Cette valeur est conservée jusqu'à un instant t₃ pour permettre à un filtre 16 numérique (figure 1) de traiter la valeur E obtenue (dans cet exemple E = 0).

A l'instant t₃, le séquenceur 22 remet à zéro le compteur 30. L'instant t₃ se produit avant le front montant suivant du signal F.

Si l'instant t₂ survient avant l'instant t₁, le compteur 30 reste à 0, ce qui correspond à une erreur E maximale positive +Emax (avance de phase du signal F par rapport au signal Fref).

Si l'instant t₂ survient après le front descendant de l'impulsion du signal Fref, le compteur atteint sa valeur maximale 511 qui correspond à une erreur de phase maximale négative -Emax (retard de phase du signal F par rapport au signal Fref).

Si l'instant t₂ survient n'importe quand dans l'impulsion Fref, le compteur 30 s'établit à une valeur comprise entre sa valeur nulle et sa valeur maximale, correspondant à une erreur de phase E proportionnelle à l'erreur de phase réelle. Par exemple, à un instant t₄, un front montant du signal F survient peu avant la fin d'une impulsion du signal Fref. Le compteur 30 atteint une valeur proche de 511 correspondant à une erreur de phase E négative et proportionnelle à l'erreur de phase réelle.

La figure 4 représente un diagramme de l'erreur de phase E fournie par le comparateur de phase de la figure 3A en fonction de l'erreur de phase réelle Er. Ce diagramme est symétrique par rapport à l'origine du diagramme. Autour de la valeur 0, l'erreur E varie proportionnellement à l'erreur réelle Er. Au-delà de cette zone linéaire, l'erreur E sature à sa valeur maximale positive ou à sa valeur maximale négative.

Pour faciliter la lecture de ce diagramme, on a représenté au niveau de points clé de ce diagramme un front correspondant du signal F et une impulsion correspondante du signal Fref.

On constate que le diagramme présente des plages linéaires à pente négative autour des abcisses π et -π. Ceci est dû au fait que le compteur 30 est également validé lorsque la fin d'une impulsion du signal Fref se produit après un front descendant du signal F, comme cela est montré dans le diagramme de la figure 4. Idéalement, la transition est brutale aux abscisses π et -π. Toutefois, ces zones linéaires aux abscisses π et -π n'entraînent aucun mauvais fonctionnement d'un PLL si les impulsions du signal Fref sont de largeur constante et correspondent au temps que met le compteur 30 à compter jusqu'à sa valeur maximale (511).

Si un comparateur de phase selon l'invention est utilisé dans le PLL d'un système de balayage horizontal de téléviseur, les plages linéaires ne correspondent qu'à environ 4,7 microsecondes sur les 64 microsecondes d'une période du signal Fref. Ceci laisserait présager que le PLL ne peut pas converger si le signal F est initialement quelconque.

En effet, on pourrait croire, lorsque le signal F est quelconque, que les centres des impulsions du signal Fref ont autant de chances de survenir lorsque le signal F est à 1 que lorsque le signal F est à 0, ce qui voudrait dire que la phase du signal F serait corrigée autant de fois dans le sens négatif que dans le sens positif avec une correction moyenne nulle.

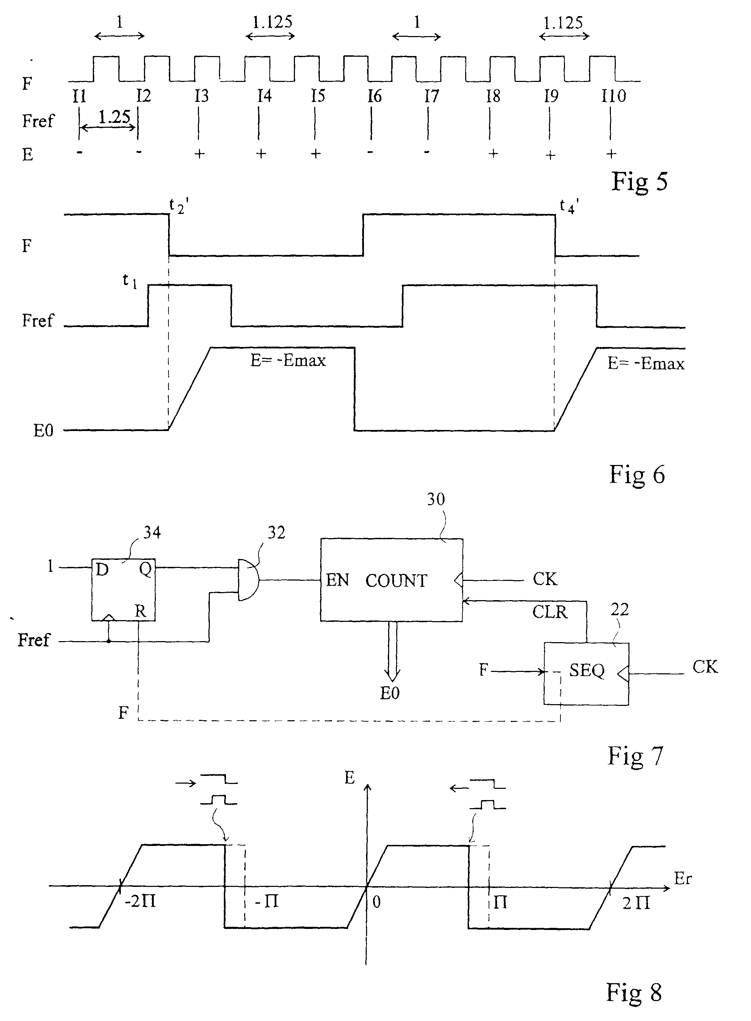

La figure 5 sert à montrer qu'un tel PLL finit par converger. La période du signal F est initialement égale à 1. La période du signal Fref est constante et égale à 1,25. Les centres des impulsions du signal Fref sont représentés par des barres verticales I1, I2... Sous chaque barre, on a représenté le signe correspondant de l'erreur E.

Le filtre 16 d'un PLL est un filtre à correction proportionnelle et intégrale. La constante de temps du filtre est particulièrement élevée, ce qui entraîne que la correction intégrale n'agit qu'à long terme, lorsqu'un grand nombre de valeurs de même signe de l'erreur de phase sont fournies. Ainsi, pour simplifier, on peut supposer ci-après que cette correction intégrale n'intervient pas. En outre, on suppose également que les valeurs d'erreur de phase sont maximales, ce qui n'est pas loin de la réalité car il y a une forte probabilité, lorsque le signal F est quelconque, que les centres des impulsions du signal Fref surviennent dans les plages de saturation de la figure 4.

Avec ces hypothèses, le filtre 16 agit sur l'oscillateur 10, qui est un synthétiseur de fréquence dans un PLL entièrement numérique, de manière à corriger la période du signal F d'une valeur constante (faible) dans le même sens que l'erreur de phase E, la correction intervenant, par exemple, au front montant du signal F survenant après la mesure de l'erreur.

Les impulsions I1 et I2 surviennent lorsque le signal F est à 0. Les erreurs E correspondantes sont négatives. Au front montant suivant l'impulsion I1, la période du signal F est réglée à 1 alors qu'elle était auparavant légèrement supérieure. La période du signal F est maintenue à 1 tant que l'erreur de phase est négative.

L'impulsion I3 survient lorsque le signal F est à 1. L'erreur E correspondante est positive. Cette impulsion I3 est assez proche d'un front montant précédent du signal F ; si la période du signal F n'avait pas été diminuée, l'impulsion I3 aurait pu survenir alors que le signal F était à 0 et produire une erreur E négative. La période du signal F passe de 1 à 1,125 au front montant du signal F suivant l'impulsion I3.

Les impulsions I4 et I5 surviennent également lorsque le signal F est à 1 ; l'erreur correspondante est positive et le signal F conserve la période de 1,125. L'impulsion I5 survient juste avant un front descendant du signal F. Si la période du signal F n'avait pas été augmentée, l'impulsion I5 aurait pu survenir alors que le signal F était à 0 et produire une erreur E négative.

Les impulsions I6 et I7 surviennent lorsque le signal F est à 0, l'erreur E correspondante est négative et la période du signal F devient 1 au front montant suivant l'impulsion I6.

Les impulsions I8 à I10 surviennent lorsque le signal F est à 1, et la période du signal F redevient 1,125 au front montant suivant l'impulsion I8.

On constate dans cet exemple qu'une majorité (3/5) des erreurs E sont de signe positif et corrigent la période du signal F dans le bon sens. Ceci est dû, dans l'exemple de la figure 5, à l'effet combiné suivant. Premièrement, lors des corrections négatives, la période du signal F est diminuée ; la période du signal Fref étant plus longue que celle du signal F, on réduit ainsi la probabilité pour que l'impulsion suivante du signal Fref se produise dans une plage (signal F à 0) où l'on détecte une erreur négative. Deuxièmement, lors des corrections positives, la période du signal F est augmentée ; la période du signal Fref étant supérieure à celle du signal F, on augmente la probabilité pour que l'impulsion suivante du signal Fref se produise dans une plage (signal F à 1) où l'on détecte une erreur positive.

Bien entendu, un raisonnement similaire s'applique au cas où la période du signal F est initialement supérieure à celle du signal Fref.

En conséquence, sur un grand nombre de périodes, on obtient plus de corrections dans le bon sens que dans le mauvais et le PLL finit par converger grâce à l'intégrateur du filtre.

La figure 6 illustre une situation où les impulsions du signal Fref ont une largeur quelconque, et en tout cas supérieure à celle correspondant à un comptage jusqu'à la valeur maximale du compteur 30. Dans ce cas, le comparateur de phase de la figure 3A fonctionne dans certains cas de manière erronée.

A un instant t₁, survient un front montant d'une impulsion du signal Fref. A un instant t₂', après l'instant t₁, survient un front descendant du signal F. Le compteur de la figure 3A est validé et se met à compter. Le compteur 30 compte tant que le signal Fref est à 1. Si l'impulsion du signal Fref est plus longue que sa valeur normale, comme cela est représenté, le contenu E0 peut atteindre sa valeur maximale correspondant à une erreur E égale à la valeur maximale négative -Emax. Le comparateur de phase indique un retard de phase maximal du signal F alors que, dans le cas de la figure 6, il est en avance de phase. Cette erreur est due au fait que, au moment des fronts descendants du signal F, on mesure la largeur de la fin d'une impulsion du signal Fref, qui n'est pas indicative de l'erreur de phase.

De façon plus générale, ce genre d'erreur est susceptible de se produire lorsque les impulsions du signal Fref sont de largeur supérieure à celle correspondant à un comptage jusqu'à la valeur maximale du compteur 30. Cette erreur est donc susceptible de se produire, comme cela est représenté à droite de la figure 6, dans un cas courant (autre que dans un balayage de téléviseur) où les signaux F et Fref ont tous deux un rapport cyclique de 0,5. Dans un tel cas, un comparateur de phase selon l'invention permet de synchroniser les fronts montants du signal F sur une position prédéterminée au début des parties à 1 du signal Fref, et non sur le centre de ces parties. Ce cas est particulièrement défavorable car on peut détecter, comme cela est représenté, un retard maximal du signal F alors que celui-ci est seulement légèrement en avance.

La figure 7 représente un mode de réalisation de comparateur de phase numérique selon l'invention permettant d'éviter l'inconvénient susmentionné. Une porte 32 reçoit, à la place de l'inverse du signal F, la sortie Q d'une bascule 34. L'entrée de donnée D de cette bascule reçoit la valeur 1, l'entrée d'horloge le signal Fref, et l'entrée de remise à 0 R le signal F. Avec cette configuration, le compteur 30 est validé seulement si un front montant du signal Fref se produit alors que le signal F est à 0. Ceci supprime les comptages erronés de la figure 6.

La figure 8 représente le diagramme de l'erreur E fournie en fonction de l'erreur réelle Er, obtenu avec le comparateur de la figure 7. Ce diagramme n'est pas symétrique et présente une transition brusque aux points où un front descendant du signal F survient en même temps qu'un front descendant du signal Fref (avant les abscisses -π et π).

Une telle asymétrie présente toutefois l'inconvénient d'augmenter la probabilité de détection d'erreurs négatives par rapport à la probabilité de détection d'erreurs positives. On risque de ne plus assurer la convergence d'un PLL.

Pour éviter cela, le diagramme est rendu symétrique, comme cela est représenté en pointillés, en diminuant la durée à 0 du signal F de la durée correspondant au comptage du compteur 30 jusqu'à la moitié de sa capacité. Cela peut être réalisé, par exemple, comme cela est représenté à la figure 7, en traitant le signal F dans le séquenceur 22 avant de le fournir à la bascule 34 de manière à retarder ses fronts descendants de 256 périodes de l'horloge CK (dans l'exemple où la valeur maximale du compteur 30 est 511).

La résolution du comparateur de phase décrit jusqu'ici est d'une période d'horloge CK, c'est-à-dire qu'en régime établi, la valeur de l'erreur de phase oscille entre -1 et +1. La résolution moyenne du comparateur peut être améliorée grâce à la configuration décrite ci-après.

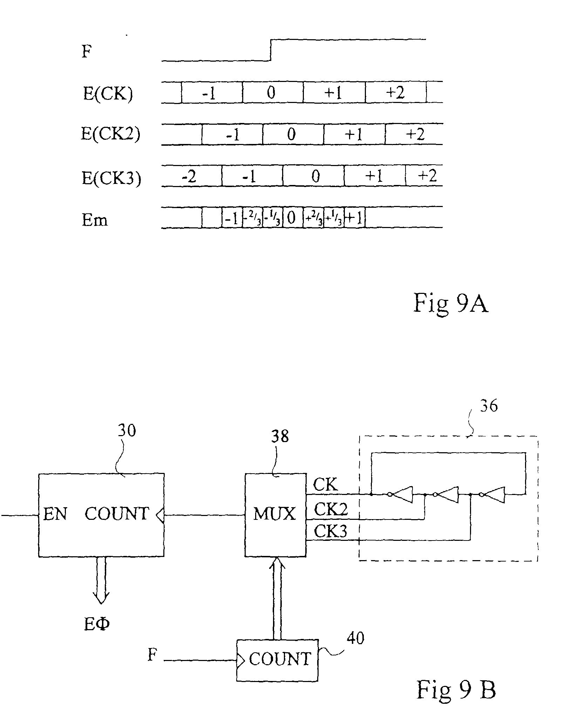

La figure 9A illustre le fonctionnement d'un PLL muni d'un comparateur de phase selon l'invention en régime établi. Le résultat E(CK) fourni par le comparateur peut être symbolisé par une règle graduée ...-1, 0, +1, +2... La valeur fournie en tant qu'erreur de phase E correspond à la graduation en face de laquelle survient un front montant du signal Fref. Dans l'exemple représenté, un front montant du signal Fref survient en face de la graduation 0, ce qui fournit une erreur de phase de 0. Toutefois, la fréquence du signal F n'est jamais exactement celle qu'elle devrait être, et le front montant se déplace autour de 0 le long de la règle, de manière que les erreurs fournies tendent à osciller entre -1 et +1.

Selon un mode de réalisation de l'invention, on propose d'augmenter en moyenne la précision des erreurs E fournies par le comparateur de phase. Pour cela, par exemple, on utilise trois règles, la règle E(CK) susmentionnée et deux règles supplémentaires E(CK2) et E(CK3) décalées l'une par rapport à la précédente d'un tiers de graduation. Ces règles sont utilisées cycliquement pour fournir l'erreur E. Dans l'exemple représenté, la première règle fournit la valeur 0, la deuxième règle fournit également la valeur 0, mais la troisième règle fournit la valeur -1. Ainsi, si le signal F reste stable, le comparateur de phase fournit la valeur -1 une fois sur trois, ce qui correspond en moyenne à une erreur de phase de -1/3.

On a représenté en dessous de la règle E(CK3) une règle Em correspondant aux erreurs de phase moyennes que l'on obtient à chaque trois périodes du signal F.

La figure 9B représente un mode de réalisation de comparateur de phase selon l'invention permettant d'augmenter la précision du comparateur selon ce qui a été décrit ci-dessus. Un oscillateur 36 fournit trois signaux d'horloge CK, CK2, CK3 de même fréquence et déphasés d'un tiers de période l'un par rapport à l'autre. L'oscillateur 36 est par exemple un oscillateur en anneau à trois inverseurs dont les sorties fournissent respectivement les signaux CK, CK2, CK3. Un multiplexeur 38 reçoit ces trois signaux d'horloge et en fournit un seul au compteur 30. Le signal d'horloge à fournir est sélectionné par un compteur jusqu'à trois 40 recevant en tant que signal d'horloge le signal F.

Bien entendu, la présente invention est susceptible de diverses variantes et modifications qui apparaîtront à l'homme de l'art, tant en ce qui concerne les exemples numériques qu'en ce qui concerne la mise en oeuvre des éléments dont la fonction a été décrite qui pourront être remplacés par d'autres éléments assurant la même fonction.

## Revendications

1. Comparateur de phase numérique fournissant des valeurs numériques (E) correspondant aux différences de phase entre un premier signal (F) et un deuxième signal (Fref), comprenant un compteur (30) à sens unique initialisé à la fréquence du premier signal et cadencé par un signal d'horloge (CK) de fréquence élevée par rapport à celle des premier et deuxième signaux, et une porte logique (32) pour valider le compteur ; caractérisé en ce que le premier signal a un rapport cyclique sensiblement égal à 0,5 et en ce que la porte logique (32) est connectée pour valider le compteur quand les premier et deuxième signaux sont à des états respectifs prédéterminés, une différence de phase étant considérée comme nulle lorsqu'elle correspond à la moitié de la capacité du compteur.

2. Comparateur de phase selon la revendication 1, caractérisé en ce qu'il comprend une bascule (34) coopérant avec ladite porte logique (32) pour valider le compteur (30) seulement quand un front prédéterminé du deuxième signal (Fref) arrive quand le premier signal (F) est à son état prédéterminé respectif.

3. Comparateur de phase selon la revendication 2, caractérisé en ce qu'il comprend un circuit (22) de traitement du premier signal (F) pour diminuer la durée de l'état prédéterminé respectif de celui-ci de la durée correspondant au comptage par le compteur (30) jusqu'à la moitié de sa capacité.

4. Comparateur de phase selon la revendication 1 ou 2, caractérisé en ce qu'il comprend un générateur d'horloge fournissant plusieurs signaux d'horloge (CK, CK2, CK3) de même fréquence mais déphasés d'une valeur constante, ces signaux d'horloge étant successivement fournis au compteur à la fréquence du premier signal.

## Patentansprüche

1. Digitaler Phasenkomparator zur Bildung von Digitalwerten (E) entsprechend den Phasenunterschieden zwischen einem ersten Signal (F) und einem zweiten Signal (Fref), welcher einen nur in einer Richtung arbeitenden Zähler (30), welcher mit der Frequenz des ersten Signals initialisiert und durch ein Taktsignal (CK) von hoher Frequenz relativ bezüglich der Frequenz des ersten und des zweiten Signals getaktet wird, sowie ein logisches Gatter (32) zur Aktivierung des Zählers aufweist,
dadurch gekennzeichnet, daß das erste Signal ein Impulstastverhältnis im wesentlichen gleich 0,5 aufweist und daß das logische Gatter (32) so geschaltet ist, daß es den Zähler aktiviert, sobald sich das erste und das zweite Signal in jeweils vorgegebenen Zuständen befinden, wobei eine Phasendifferenz als Null betrachtet wird, sobald sie dem halben Wert der Zählkapazität des Zählers entspricht.

2. Phasenkomparator nach Anspruch 1,
dadurch gekennzeichnet, daß er eine Kippschaltung (34) aufweist, welche mit dem genannten logischen Gatter (32) zusammenwirkt, derart daß der Zähler (30) nur dann aktiviert wird, wenn eine vorgegebene Flanke des zweiten Signals (Fref) auftritt, während sich das erste Signal in seinem betreffenden vorgegebenen Zustand befindet.

3. Phasenkomparator nach Anspruch 2,
dadurch gekennzeichnet, daß er eine Schaltung (22) zur Bearbeitung des ersten Signals (F) umfaßt, um die Dauer des betreffenden vorgegebenen Zustands dieses Signals um die Dauer, welche dem Zählvorgang des Zählers (30) bis zu seiner halben Zählkapazität entspricht, zu verringern.

4. Phasenkomparator nach Anspruch 1 oder 2,
dadurch gekennzeichnet, daß er einen Taktgenerator zur Erzeugung mehrerer Taktsignale (CK, CK2, CK3) von gleicher Frequenz, die jedoch gegeneinander in der Phase um einen konstanten Wert versetzt sind, aufweist, und daß diese Taktsignale aufeinanderfolgend dem Zähler mit der Frequenz des ersten Signals zugeführt werden.

## Claims

1. A digital phase comparator supplying digital values (E) corresponding to the phase shifts between a first signal (F) and a second signal (Fref), including a one-way counter (30) initialized at the frequency of the first signal and clocked by a clock signal (CK) having a high frequency with respect to the frequency of the first and second signals, and a logic gate (32) for enabling the counter; characterized in that the first signal has a duty cycle of substantially 0.5 and in that the logic gate (32) is connected to enable the counter when the first and second signals are in respective predetermined states, a phase shift being considered as zero when it corresponds to one half of the counter's capacity.

2. The phase comparator of claim 1, including a flip-flop (34) cooperating with said logic gate (32) to enable the counter (30) only when a predetermined edge of the second signal (Fref) occurs when the first signal (F) is at its respective predetermined state.

3. The phase comparator of claim 2, including a processing circuit (22) for decreasing the duration of the respective predetermined state of the first signal (F) by the duration corresponding to the counter (30) counting up to half its capacity.

4. The phase comparator of claim 1 or 2, including a clock generator providing a plurality of clock signals (CK, CK2, CK3) having the same frequency but phase shifted by a constant value, said clock signals being successively provided to the counter at the frequency of the first signal.
